# EUROPEAN PATENT SPECIFICATION

(11) **EP 2 426 685 B1**
(45) Date of publication and mention of the grant of the patent: **21.10.2015**
(21) Application number: 10306325.1
(22) Date of filing: 30.11.2010
(51) Int. Cl.: H01G 9/20, C03C 3/11, C03C 4/08, C03C 27/06, C03B 23/203, C03B 23/20

(54) **Process for sealing a glass package and resulting glass package**
Verfahren zur Abdichtung einer Glasverpackung und daraus resultierende Glasverpackung
Procédé d'étanchéification d'un emballage de verre et emballage de verre ainsi obtenu

(30) Priority: 03.09.2010 US 379874 P
(43) Date of publication of application: 07.03.2012
(60) Divisional application: 15184243.2
(73) Proprietor: Corning Incorporated, Corning NY 14831 (US)
(72) Inventor: Lvovich Logunov, Stephan, Corning, NY 14830 (US); Prassas, Michel, 77300 Fontainebleau (FR)
(74) Representative: Le Roux, Martine

(56) References cited:
- EP-A2- 1 137 022
- WO-A1-2008/093962
- WO-A1-2010/064213
- US-A1- 2005 151 151
- US-A1- 2010 059 113
- R. SASTRAWAN ET AL.: "New interdigital design for large area dye solar modules using a lead-free glass frit sealing", PROGRESS IN PHOTOVOLTAICS: RESEARCH AND APPLICATIONS, vol. 14, no. 8, 2006, pages 697-709, XP008144509, DOI: 10.1002/pip.700

## Description

This disclosure relates to a process for sealing glass packages containing liquid, and more particularly, a heat sensitive liquid, such as an organic electrolyte solution in sensitized dye solar cells, and more particularly, to a process for sealing fill holes in a heat sensitive liquid containing glass package by laser sealing a glass patch over the fill holes.

Due to the volatile supply, high costs and environmental concerns with conventional energy sources such as oil and coal, the research, development and use of alternative energy sources has increased in recent years. One alternative energy source that has been garnering increased research and use in recent years is photovoltaic devices or solar cells that convert the sun's photons into electricity. Currently, the most widely used solar cells are silicon based photovoltaic devices. However, the high cost of silicon combined with the relatively low efficiency and electrical output of these devices make them economically unviable for many applications.

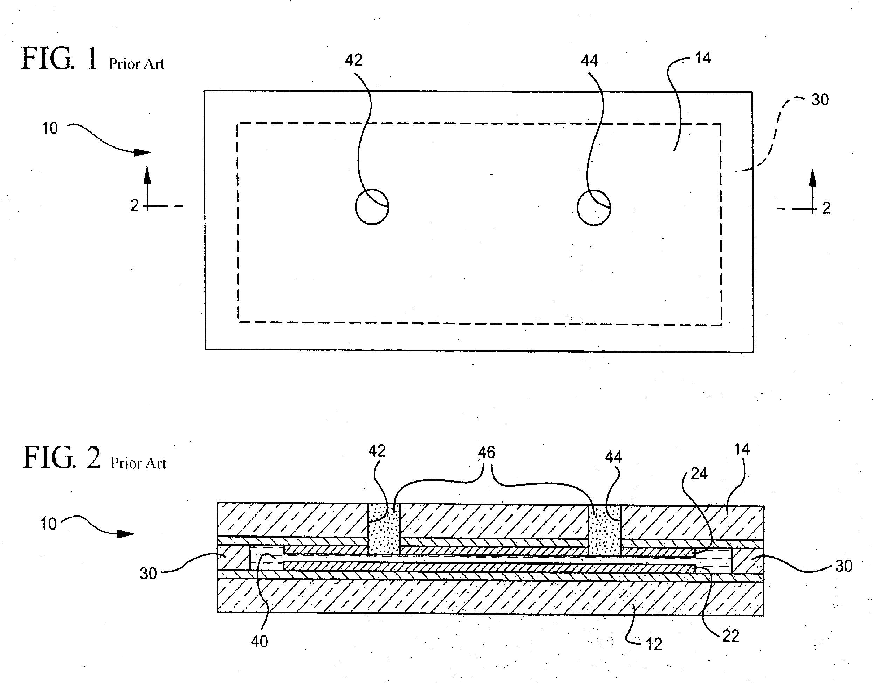

A relatively newer, less expensive approach to photovoltaics is dye solar cell technology discovered by Michael Grätzel that uses dye sensitized mesoscopic oxide particles between two electrode bearing glass plates to convert sunlight into electricity. One type of dye solar cells is an organic dye solar cell, which contains dye and a heat sensitive organic electrolyte solution. As illustrated in Figures 1 and 2, current organic dye solar cell module designs 10 typically include two glass plates 12 and 14, each with a thin conductive coating 22, 24 separated by approximately 20 µm to 30 µm. One of the glass plates 12 is coated on its inside surface with a thin TiO₂ layer electrode layer 22 that serves as an anode electrode. The other glass plate 14 is coated with a thin Pt layer electrode layer 24 on its inner surface that serves as a cathode electrode. As is well understood in the art, a solar panel cell module typically consists of many solar dye cells between the two glass plates. Collection electrodes (such as Ag silver electrodes, not shown) extend to each cell to collect current from each cell. The electrode layers can withstand temperatures of up to 450° C, so the two glass plates may be sealed together with a loop of low melting temperature glass frit 30 or other inorganic low melting temperature sealing material. The loop of frit 30 may be pattern/deposited over the electrode layer 22 on the first glass plate 12 (or the second glass plate 14). The second glass plate 14 is then placed against the first glass plate with the electrode layer 24 on the second glass plate in contact with the loop of frit 30 on the first glass plate 12. Individual cell modules may contain several cells connected in series, in which case, a common frit loop may surround, seal and isolate all of the cells in the module as a group.

The entire assembly is then heated in an oven to a temperature above the melting temperature of the frit material, but below 450° C, in order to melt the frit material. The assembly is then cooled, such that the frit hardens and joins the two glass plates 12 and 14 together and forms a hermetic seal around the periphery of the solar cell or the periphery of the two glass plates 12 and 14. Since collector electrodes (such as Ag electrodes, not shown) may be sensitive to corrosion by the electrolyte material contained in an organic dye solar cell, the sealing perimeter for each cell isolates the active cell areas filled with electrolyte solution from the Ag electrodes. The loop of frit 30 is deposited with a height such that it forms approximately a 20 µm to 30 µm gap between the two glass plates after melting and hardening of the frit, thereby creating a cell cavity 40 between the two glass plates 12 and 14. The two glass plates 12 and 14 may alternatively be sealed together at room temperature with a polymeric sealing material in place of the inorganic sealing material. However, a polymeric sealing material does not form a hermetic seal and the useful lifetime of the cell is therefore detrimentally effected compared to a cell that is hermetically sealed with an inorganic material.

Each dye solar cell typically has at least one, or typically two or more fill holes 42 and 44 through one of the glass plates. After sealing the two glass plates together with the frit material, the fill holes are used to stain the inner surfaces of the two glass plates with a dye solution and the dye solution is removed from the cell cavity. The fill holes are then used to fill the cell cavity 40 with an electrolyte solution by inserting the electrolyte solution through one of the fill holes into the cell cavity until the cavity is completely filled with solution in a second step, while air is allowed to escape through the second fill hole to prevent the formation of air bubbles in the cavity. The fill holes are then typically closed and sealed with a polymeric sealing material 46, which does not form a hermetic seal.

Polymeric sealing materials are typically employed to seal the fill holes due to the heat sensitive nature of the organic electrolyte solution contained in the cell. A sealing process that would heat any portion of the organic electrolyte solution contained in the cell to a temperature above 120° C or above about 150° C cannot be employed to seal the fill holes without detrimentally affecting or degrading the organic electrolyte solution. Glass frit and other inorganic sealing materials typically have a melting point of a least 450° C or higher. It is therefore difficult to employ a hermetic inorganic sealing material, such as glass frit, (it has however to be noted that the use of such a glass frit is disclosed in WO Patent Application No.2008/093962 while the use of a low-melting glass is disclosed in EP Patent Application No.1,137,022 and the use of a glass precursor, a glass paste or glass powder, of low and very low melting point is disclosed in WO Patent Application No.2010/064213), for sealing the fill holes without damaging the organic dye material contained in the cell. As a result, polymeric sealing materials are typically used to seal the fill holes, so that the fill holes can be sealed at approximately room temperatures below 150° C without damaging the organic electrolyte solution contained in the cell during the sealing process. However, such a polymeric seal is not hermetic, which limits the useful lifetime of the solar cell. There is therefore a need in the art for a low cost process for hermetically sealing the fill holes in an organic dye solar sell. U.S. Patent Application No.2010/0059113 discloses a dye-sensitized solar cell, the seal members of which (to bond the pair of glass substrates and to seal the fill holes with glass sheets) are composed of a material cured by photopolymerizing a photopolymerizable composition.

The owner of this application, Corning Incorporated, has developed a process for sealing the perimeter of heat sensitive devices, such as organic light emitting diode devices, by heating the loop of frit between two glass plates encapsulating the devices with a laser beam. For example, see Coming owned U.S. Patent Numbers 6,998,776; 7,407,423 and 7,344,901. However, these sealing processes were developed for relatively low coefficient of thermal expansion (CTE) materials, such as Corning Incorporated's Eagle™ display glass, which is a relatively expensive high quality glass developed for use in the production of liquid crystal displays. Organic dye solar cells, on the other hand, are typically manufactured with relatively low cost, low quality and relatively high CTE, as compared with display glass, soda lime glass due to the cost targets required to make solar cells economically feasible. Soda lime glass typically has a CTE in a range from about 80x10⁻⁷ to about 90x10⁻⁷ per degree C, while Coming's laser sealing technology was primarily developed for sealing the perimeter of lower CTE glasses, for example, glasses with a CTE <50x10⁻⁷ per degree C. The difference between the CTE of soda lime glass and the CTE of display glass makes a big difference in sealing performance due to the increased residual and transient stresses created in the frit and soda lime glass compared to the stresses created in the frit and glass when sealing relatively low CTE display quality glass. These processes were also developed for sealing a loop of glass frit having a perimeter > 30 mm long, not for sealing a small 2 mm diameter hole. Furthermore, these sealing processes were not developed for sealing a cell that is completely filled with temperature sensitive materials, such as an organic electrolyte solution. In these existing processes, the temperature sensitive materials or devices, such as OLED devoices, must be offset from the perimeter frit seal/wall by a minimum distance in order to prevent overheating of the organic sensitive material or devices during laser sealing. It is not possible to space a liquid solution filling the cell from the fill holes without the costly addition of additional space consuming and costly structure for just this purpose.

Coming Incorporated has also developed a process for laser frit sealing the perimeter of relatively higher CTE glasses such as soda lime glass, for example see published U.S. Patent Application No. 2010/0129666 and published international application WO 2010/014161, but there are restrictions on the glass thickness that may be effectively sealed using these processes. Using this process for laser frit sealing relatively higher CTE glass plates having a thickness equal to or greater than about 2.2 mm, which is approximately the lower thickness limit for the float process used to manufacture low cost soda lime glass plates as are typically used for dye solar cells, results in unsatisfactorily low yields, making this process economically unviable and ineffective for sealing organic dye solar cells manufactured with such high CTE glass plates. Furthermore, as described above, organic dye solar cells typically include conductive coatings on the soda lime glass plates, which makes sealing even more difficult and results in even lower yields. In these processes, the solution inside the cell contacting the frit is typically heated during the sealing process to relatively high temperatures, e.g. the melting temperature of the frit, that are unacceptable when sealing organic dye solar cells.

Coming Incorporated has also developed a process for laser frit sealing the perimeter of devices containing liquid, for example see aforementioned published international application WO 2010/014161. However, as previously described in relation to the laser sealing process disclosed in published U.S. Patent Application No. 2010/0129666 and published international application WO 2010/014161, these processes were developed for sealing display quality glass. Laser frit sealing of devices made with economical soda lime glass plates with these processes would likely result in unsatisfactorily low yields. Also, these existing processes were not developed for sealing glass packages containing heat sensitive solutions or devices.

There is a need in the art for a process for economically sealing the fill holes in a sensitized organic dye solar cell in an economical soda lime glass package with a hermetic inorganic sealing material. Furthermore, there is a need for a less expensive manufacturing process to make many different types of glass packages that contain a liquid or devices that may be heat sensitive, such as, for example, electro-wetting displays and OLED displays. This need and other needs are satisfied by the disclosed method for sealing a glass package and the resulting glass package.

### SUMMARY

According to at least one embodiment of this disclosure, a method is provided for encapsulating/sealing one or more fill holes in a glass package containing heat sensitive liquid, such as an organic dye solar cell, by covering the hole(s) with a thin (for example, < about 0.7 mm thick) laser absorbing cover glass or glass patch having a CTE of less than about 50x10⁻⁷ per degree C. The perimeter of the glass patch is then melted, thereby fusing glass patch to the glass plate and hermetically sealing to the hole in the glass plate. The perimeter of the glass patch is heated, for example with a laser, in such a manner that the entire perimeter of glass patch is uniformly heated to a substantially uniform temperature without heating the electrolyte solution in the package to a temperature over 120° C or over 150° C.

According to a further embodiment hereof, a method is provided for encapsulating one or more fill holes in a glass plate of an organic dye solar cell by covering the hole(s) with a thin cover glass. The perimeter of the cover glass is hermetically sealed to the glass plate using a laser to melt a laser absorbing loop of frit in such a manner that the loop of frit is uniformly heated to the same temperature without heating the electrolyte solution in the package to a temperature over 120° C or over 150° C.

Additional features and advantages will be set forth in the detailed description which follows and will be readily apparent to those skilled in the art from the following description or recognized by practicing the embodiments as described in the following the detailed description, claims, and appended drawings.

It is to be understood that both the foregoing general description and the following detailed description are merely exemplary, and are intended to provide an overview or framework to understanding the nature and character of the claims. The accompanying drawings are included to provide a further understanding, and are incorporated in and constitute a part of this specification. The drawings illustrate one or more embodiment(s), and together with the description serve to explain principles and operation of the various embodiments.

### BRIEF DESCRIPTION OF THE DRAWINGS

Figure 1 is a diagrammatic plan view of a Prior Art organic dye solar sell;
Figure 2 is a cross-sectional side view of the Prior Art organic dye solar sell of Fig. 1 taken along line 2 - 2 in Fig. 1;
Figure 3 is a diagrammatic plan view of a sealed organic dye solar sell according an embodiment hereof;
Figure 4 is a cross-sectional side view of the organic dye solar sell of Fig. 3 taken along line 4 - 4 in Fig. 3;
Figure 5 is a diagrammatic illustration of a system for sealing the fill holes of a dye solar cell according to an embodiment hereof;
Figure 6 is a plot illustrated the laser power profile according to an embodiment hereof; and
Figure 7 is a diagrammatic illustration of a system for sealing the fill holes of a dye solar cell according to another embodiment hereof.

### DETAILED DESCRIPTION

Reference will now be made in detail to the exemplary embodiment(s) hereof as illustrated in the accompanying drawings. Where possible, the same reference numerals are used throughout the drawings to refer to the same or like parts.

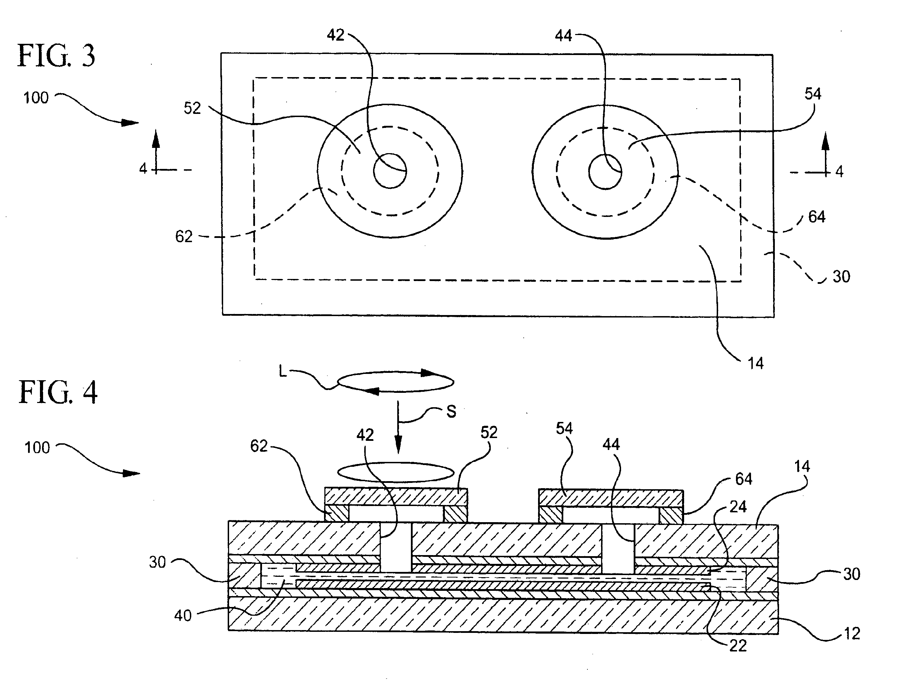

Referring now to Figs. 3 and 4, there is disclosed an organic dye solar cell 100 that has been sealed in accordance with an embodiment hereof. The organic dye solar cell 100 includes a first glass plate 12 and a second glass plate 14. Anode electrodes may be formed on the inner surface on the first glass plate by a thin TiO₂ layer 22 on top of a thin conductive coating (TCO). The TiO₂ electrode may have a thickness of approximately about 2 µm to about 8 µm, which is less than the width of the gap formed between two glass plates. A thin conductive Pt salt layer 24 may be formed on the inner surface of the second glass plate 14 to form a cathode electrode. An outer peripheral portion of the inner surface of the first glass plate may bee fused and hermetically sealed to an outer peripheral portion of the inner surface of the second glass plate by a loop (or looped wall or frame) of glass frit or other inorganic sealing material 30. The loop of frit 30 also serves to space the inner surface of the first glass plate from the inner surface of the second glass plate by a distance of about 20 µm to about 30 µm, thereby forming a cell cavity 40 between the two glass plates 12 and 14 for containing the organic electrolyte solution. The cell cavity is defined by an interior side of the frit, the inner surface of the first glass plate 12 and the inner surface of the second glass plate 14. The details of the material and structure of the electrode layers; the composition, deposition and melting of frit; and the composition of the organic electrolyte solution are well known in the art and are not described in detail herein. The present disclosure is primarily directed at the hermetic sealing of the glass package and the hermetic sealing of fill holes in one of the glass plates.

The second glass plate 14 includes at least one, or typically two or more fill holes 42 and 44 having a diameter of up to 2 mm passing therethrough for filling the cell cavity 40 with organic electrolyte solution as described in more detail below. The fill hole(s) may alternatively be located in the first glass plate 12, but may then block the light from irradiating the cell. One or more glass patches 52 and 54 cover the two or more fill holes 42 and 44. Two fill holes 42 and 44 and two corresponding glass patches 52 and 54 are illustrated in Figs. 3 and 4. However, if the fill holes may be placed close enough together, then a single glass patch may cover and seal both of the fill holes. An outer peripheral portion of the inner surface of the glass patches 52 and 54 are fused and hermetically sealed to the outer surface of the second glass plate by loops (or looped walls or frames) of glass frit sealing material 62 and 64. The fill holes 42 and 44 are thus hermetically sealed by the glass patches 52 and 54 and frit loops 62 and 64, forming a completely hermetically sealed solar dye cell or glass package 100.

Only one solar cell is illustrated in the Figures 2-4. However, typically there will be a plurality of solar cells between the first and second glass plates in a single cell module. Typically, the cavities of all cells in a module are connected together, so that only a single pair of fill holes is required to fill all the cells in a module. However, if the cells in a module are not interconnected, then each cell may have its own pair of fill holes. Current gathering electrodes are formed on the glass plates between the cells to collect the current from the cathode and anode of each cell.

By way of example, a method for manufacturing the sealed glass package 100 in accordance with an embodiment hereof will now be described. First, the first glass plate 12 and the second glass plate 14 with at least one, or typically two or more fill holes 42 and 44 therethrough are provided. The first and second glass plates are transparent glass plates, such as soda lime glass plates or glass plates like the ones manufactured and sold by Coming Incorporated under the brand names of Code 1737 glass or Eagle 2000™ glass. Alternatively, the first and second glass plates can be transparent glass plates like the ones manufactured and sold by companies like Asahi Glass Co. (e.g., OA10 glass and OA21 glass), Nippon Electric Glass Co., NH Techno and Samsung Corning Precision Glass Co. (for example). If desired, one of the glass plates may be non-transparent. For dye solar cell and other cost sensitive applications that do not require display quality glass, the first and second glass plates may be relatively cheap, relatively high CTE glasses, such as soda lime glass, having a coefficient of thermal expansion (CTE) in the range from about 80x10⁻⁷ to about 90x10⁻⁷ per degree C. Typically, such economical glasses have a thickness of about 2.2 mm or more. Relatively more expensive relatively low CTE display quality glasses with a CTE of a less than about 50 x10⁻⁷ per degree C may be required for display applications. The TC (transparent conductive) electrode layers, and any other desired electrical components (e.g., OLEDs 106) and associated electrodes, are deposited onto the first glass plate and the second glass plate, as is well understood in the art. This particular step can be omitted if a glass package that contains only a liquid is being made in accordance with the sealing process of the present invention.

Frit 30 is then deposited around the outer periphery of a first, inner surface of the first glass plate 12 over the electrode layer 22, such that the frit forms a closed-loop on the inner surface of the first glass plate. For instance, the frit can be placed approximately about 1 mm away from the free edges of the first glass plate 102. The frit may then be pre-sintered to the first glass plate in an oven, so that the frit becomes attached to the first glass plate and is hardened to inhibit damaging of the loop of frit. If desired, the pre-sintered frit 110 can be ground to reduce its thickness variation.

The inner surfaces of the first 12 and second 14 glass plates with the electrodes thereon are placed together, with the loop of frit 30 on the first glass plate contacting a first, inner surface of the second glass plate. The plates can be sealed in a furnace at a temperature that is higher than the melting point of the glass frit but lower than the softening temperature of the glass plates, such as up to about 400° C, to melt the frit and hermetically seal the glass plates together. In one embodiment, the frit 30 may be a low temperature glass frit. In the case of relatively high CTE glass plates, such as soda lime glass plates having a CTE in a range from about 80x10⁻⁷ to about 90x10⁻⁷ per degree C, it may be desirable to use a frit with a CTE that substantially matches that the CTE of the glass plates.

Next the dye solution is deposited into the cell cavity 40 through the holes to stain TiO₂ electrode. Then dye solution is removed and package is dried.

Next, the organic electrolyte solution is deposited into the cell cavity 40 through a first of the fill holes 42 until the cavity is completely filled with solution. As the cell cavity fills with organic electrolyte solution, air escapes out a second of the fill holes 44, such that no air bubbles remain in the cavity.

A sealing cover glass or glass patch 52 having a loop (or looped wall or frame) of glass frit sealing material 62 deposited on and pre-sintered (as previously described herein relative to the loop of frit on the first glass plate) to a first or inner surface of the glass patch is provided. The glass patch 52 is placed on the outer surface of the second glass plate 14 with the loop of frit on the inner surface of the glass patch placed against the outer surface of the second glass plate surrounding a first or one of the fill holes 42. A sealing device (e.g., a laser or infrared lamp or other high energy beam) is then used to melt the glass frit 62 (arrow S in Figs. 3 and 4 indicates a laser beam), thereby attaching the glass patch 52 to the second glass plate 14 and hermetically sealing the first fill hole 42 with the first glass patch and loop of frit without heating the electrolyte solution in the to a temperature over about 120° C or over about 150° C. A second glass patch 54 is placed over the second or other of the fill holes 44, and the sealing device is used to melt the glass frit 64, thereby attaching the second glass patch to the second glass plate and hermetically sealing the second fill hole with the second glass patch and loop of frit. As previously described, a single glass patch with a single loop (or two loops) of frit that surrounds both of the fill holes in the glass plate may alternatively be employed to seal both of the fill holes. A sealed dye solar cell or glass package 100 that is hermetically and durably sealed entirely with inorganic glass frit sealing material 30, 62, and 64 is thus provided.

The sealing wavelength is different from any absorption peaks of the solar cell components so that only the frit material is heated during sealing. For example, the solar cell may be designed with a high absorption of Sun light. The sealing wavelength may be outside of the absorbing range of the cell components, such as a wavelength that is longer than about 750 nm or substantially equal to or longer than about 800 nm, or substantially equal to or longer than about 810 nm. The absorbing frit or the absorbing glass of the sealing line may then be designed to absorb light in these frequencies, e.g. longer than about 750 nm, or substantially equal to or longer than about 800 nm, or substantially equal to or longer than about 810 nm.

The seal contains the organic electrolyte solution or other liquid in the cell cavity between the first glass plate and the second glass plate. In addition, the seal protects any electrical components contained within the cavity by preventing, for example, oxygen and moisture located within the ambient environment from entering into the sealed glass package.

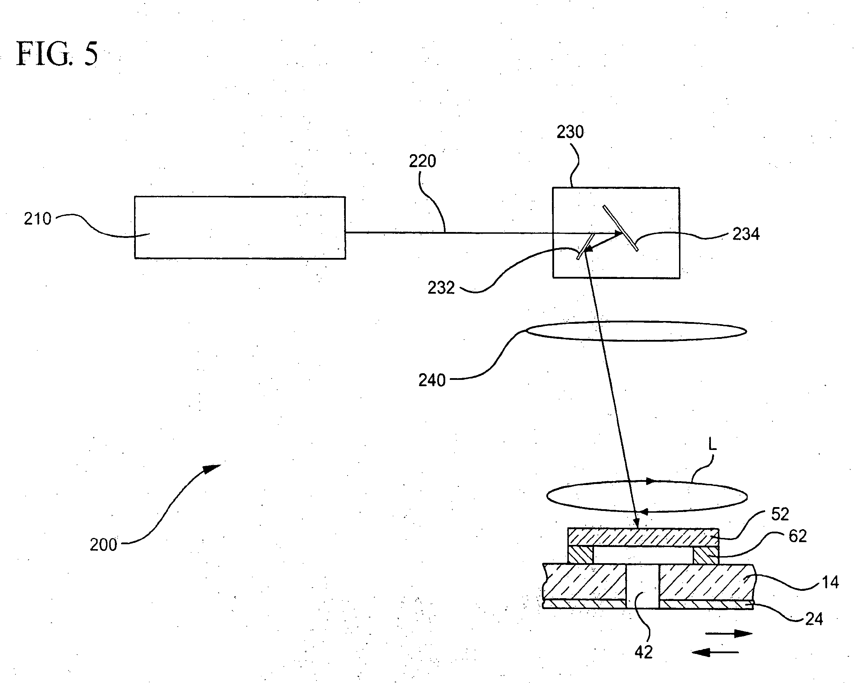

According to an embodiment hereof, the sealing device can be used to emit a concentrated beam of light (such as a laser beam, or infrared beam) that heats the frit loop 62, 64 in a manner such that the temperature of the frit loop is uniformly increased to a substantially constant temperature around its entire periphery. As illustrated by arrow L in Figs. 4 and 5, the laser beam 220 is moved along the loop of frit 62, 64 (e.g. along a sealing line). In order to minimize temperature variations and resulting stresses in the frit, glass patch and second glass plate, for a frit line width of about 0.7 mm and a laser beam spot size of about 1 mm in diameter, for example, the laser beam is repeatedly moved quickly around the loop of frit at a relatively high speed in range from about 1 m/s to about 2 m/s (e.g. fast scanned). In this manner, the temperature of the entire frit loop is raised bit by bit with each pass/circuit of the laser beam, such the temperature of the frit is always substantially the same or equal around the entire loop of frit. The temperature of the frit is raised (for example to about 400° C) until the frit melts, connecting the glass patch to the second glass plate and forming the hermetic seal, without heating the electrolyte solution in the cell cavity to a temperature over about 120° C or over about 150° C, or only heating it to a temperature in a range from about 100°C to about 120°C. This constant temperature sealing technique is described in more detail after a discussion is provided about some exemplary glass patches, glass packages and glass frits that can be used to make the dye solar cell or other glass package.

An exemplary process for fabricating a glass patch will now be described. First, a glass patch is provided. The glass patch may be a relatively thin patch of display quality glass, such as Coming Eagle glass having a thickness in range from about 0.4 mm to about 0.7 mm. Glass frit or other inorganic sealing material is deposited around the outer periphery of a first, inner surface of the glass patch, such that the frit forms a closed-loop on the outer peripheral portion of the first inner surface of the glass patch. For instance, the frit can be placed approximately about 1 mm or less away from the free edges of the first glass patch.

In an alternative embodiment hereof, a glass patch formed of a light absorbing glass is provided with a thickness in range from about 0.4 mm to about 0.7 mm. The absorbing glass patch may be formed of a dark glass, such as glass having by weight percentage a composition including 54.92% SiO₂, 5.93% Al₂O₃, 23.27% B₂O₃, 0.43% Li₂O, 1.92% K₂O, 3.25% Fe₂O₃, 6.13% CuO, 2.64% V₂O₅, 1.48% Cl, such that the entire glass patch is formed of a dark light absorbing glass. Such a dark light absorbing glass may have a relatively low CTE of less than 40x10⁻⁷ per degree C, or from about 35x10⁻⁷ per degree C to about 40x10⁻⁷ per degree C. Alternatively, the absorbing glass patch may be display quality glass, such as Coming Eagle glass, may be doped with at least one of V oxide, Cu oxide, Ti oxide, Fe oxide and Cu to make the glass patch a dark light absorbing glass patch with a relatively lower CTE of from about 35x10⁻⁷ per degree C to about 40x10⁻⁷ per degree C). Alternatively, only the outer peripheral portion of the glass patch, e.g. the sealing line, may be doped or coated with a light absorbing material or dopant, such as V oxide, Cu oxide, Ti oxide, Fe oxide, Cu or a mixture thereof, such that only the outer peripheral portion (e.g. a sealing line or loop around the edge of the glass patch) is light absorbing.

In an alternative embodiment hereof, an absorbing glass patch or a glass patch with a light absorbing sealing line (with no loop of frit thereon) is placed over one of more of the fill holes 42 and 44 with the sealing line surrounding one or more of the fill holes as previously described herein. The sealing device is then used to uniformly heat the outer peripheral portion of the absorbing glass patch (e.g. the sealing line) to a substantially equal temperature around the entire periphery of the absorbing glass patch by repeatedly moving the laser beam (or other light or energy beam) quickly around the outer periphery of the glass patch as previously described herein. The laser light is absorbed by and heats the absorbing glass of the glass patch along the sealing line. The outer peripheral/sealing line portion of the absorbing glass patch is thus uniformly heated to a substantially uniform temperature that is high enough to soften or melt the outer periphery of the absorbing glass patch (for example to about 400°C) and thereby fuse the outer peripheral portion of the inner surface of the absorbing glass patch to the second glass plate, thereby attaching the absorbing glass patch to the second glass plate and hermetically sealing the fill hole(s) while minimizing the creation of real time and residual thermal stresses, without heating the electrolyte solution in the cell cavity to a temperature over about 100° C, over about 120°C, or over about 150°C, or in a range from about 100°C to about 120°C.

Some embodiments disclosed herein describe the sealing of two dissimilar glasses with a goal to encapsulate a hole in one of the glasses. The glass with the hole may be a relatively inexpensive high CTE glass with a CTE in a range of from about 80x10⁻⁷ to about90x10⁻⁷ per C, whereas as the encapsulating glass, e.g. the glass patch, is a relatively low CTE glass with a CTE of less than about 50 x 10⁻⁷per degree C. The sealing processes of embodiments hereof are designed to maintain the temperature in the cell cavity, or on the side of the second glass plate opposite the glass patch, at room temperature, or at least below a slightly elevated temperature limit in a range from about 100°C to about 120° C, or to a temperature not over about 100°C, not over about 120° C or not over 150° C, so as not to detrimentally effect the organic electrolyte solution in the cell cavity. The temperature limitation is due the heat sensitive organic materials in the organic electrolyte solution contained within the cell cavity that will degrade at higher temperatures. The sealing may be done by uniformly heating the loop of frit or sealing line around the outer periphery of an absorbing glass patch to a temperature above the glass softening or melting temperature of the glass frit or the absorbing glass, as the case may be, so that glass frit or glass softens or melts and can flow and bond to the other glass plate glass. Heating occurs for a relatively short period of time, so that heat doesn't diffuse too far from the sealing line and does not heat the solution or other electrical elements in the cell cavity 40. The laser heats the sealing line to a substantially equal temperature around the entire loop of frit or sealing line in order to minimize thermal gradients and resulting thermal stresses in the frit and glass. As described in more detail hereinafter, this can be achieved by a fast scanning of a focused laser beam with a laser scanner, or by using optics to generate a desired stationary loop-shaped beam that will illuminate the entire loop all at once. The estimated amount of energy required is expected to be the same in either case.

According to an embodiment hereof, a sealing device 200 for the fast scanning of a laser beam (or other light or energy beam) around the sealing line or frit loop as previously described is illustrated by way of example in Fig. 5. The sealing device 200 includes a source 210 of a concentrated energy or collimated light beam 220, such as a laser. The laser emits a laser beam that is scanned such that the light beam rapidly and repeatedly travels (scans) around sealing line or frit loop (which may be a circular loop or other sharpened loop, such an ellipse, rectangle, etc.) at a relatively high speed, such as in a range from about 1 m/s to about 2m/s, as indicated by the arrow L in Fig. 5. The scanning device may have one or more rotating mirrors 232 and 234 that direct the laser beam 220 along the x and y axis in a known manner. The glass plates and the glass patch may be located on a plate that moves in the x and/or y axis to assist in the scanning, or they may be located on a stationary platen or table. The laser beam may be focused by a telecentric or other lens 240 onto the sealing line. The lens maintains the same laser spot size as the laser beam travels around the sealing line. Fast scanning with a laser quickly and uniformly heats the entire loop of frit or outer periphery of an absorbing glass patch to a substantially even/uniform temperature provided that the scanning period, e.g. the time it takes for the beam to complete one loop or circuit around the sealing line, is less than the time it takes for the temperature of the frit (or sealing line in an absorbing glass patch) to cool back down below a certain temperature below the peak temperature that is at least somewhat above the temperature of the frit just prior to the just completed circuit around the sealing line.

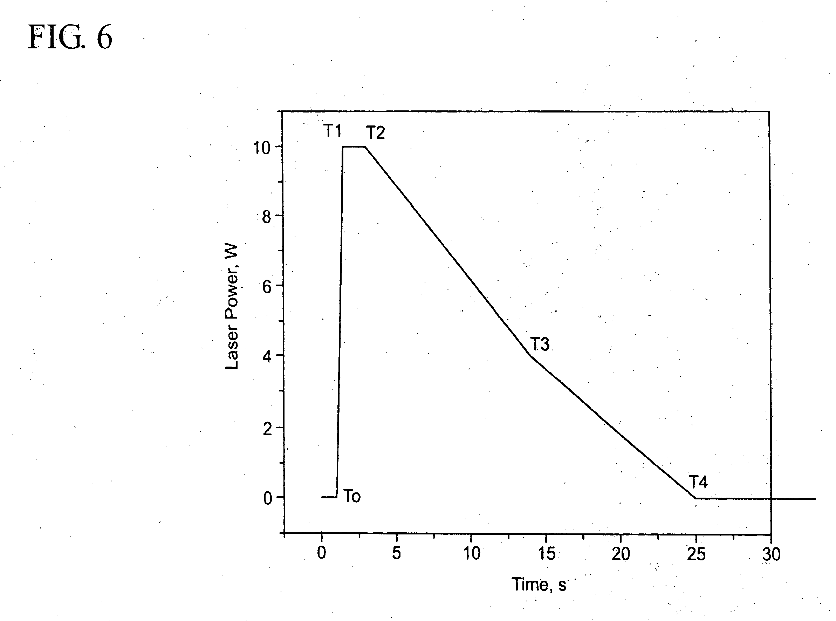

Fig. 6 illustrates a possible heating profile according to an embodiment hereof for rapidly and uniformly heating the loop of frit (or absorbing glass patch) to melt the frit and then gradually cooling the frit over at least at least 20- 30 seconds in order to minimize residual stresses in the frit and glass. During a start up phase from T0 to T1, the laser (or other light or energy beam) is quickly ramped up to peak power, such as 10 watts. During a heating or melting phase from T1 to T2, the laser is maintained at peak power for a period of time (the "holding time") in order to raise the loop of frit to its melting temperature and melt the frit. The holding time or heating phase may be about 3 seconds in length. Rapid heating during the start up and heating phases prevents heat from migrating to the cell cavity and overheating the heat sensitive liquid in the cavity, while substantially uniform heating reduces thermal stresses created in the sealing line, frit loop and glass during heating. Next, during a first cool down phase from time T2 to time T3, the laser power is gradually reduced at a first rate of power reduction down to, for example, 4 watts, in order to gradually cool/lower the temperature of the frit or absorbing glass patch down to its annealing point. During a second cool down phase from time T3 to time T4, the laser power is gradually reduced at a second rate of power reduction, which is slower than the first rate of power reduction, down to zero watts, in order to gradually cool the frit through its strain point. Gradual cooling reduces the amount of residual stresses in the glass and the frit, which is needed the most when sealing two glasses having a CTE mismatch, but is also important when sealing two CTE matched glasses. Another way to minimize real time and residual thermal stresses is to preheat the assembly on heated table (or on hot plate or in an oven) so that the temperature differential between the frit at its peak/melting temperature and the remainder of the assembly, (such as the second glass plate with the hole being sealed and the rest of the glass patch) is less than what it would be without preheating of the assembly. The entire assembly may then be slowly cooled following laser sealing as previously described herein.

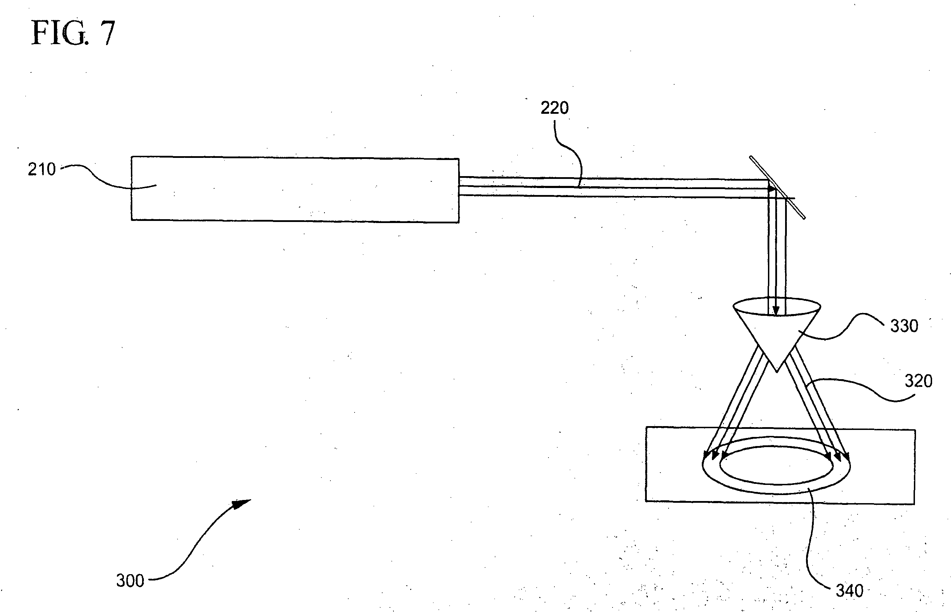

An alternative sealing device 300 for rapidly and uniformly heating the sealing line or frit loop with a stationary loop-shaped beam 320 is illustrated by way of example in Fig. 7. The alternative sealing device includes a source of a concentrated energy or collimated light beam 210, such as a laser. The laser emits a laser beam 220 that is transformed with special shape axicon or other suitable lens 330 into a hollow cone of light 320. As a result, the laser beam is transformed into an annular, donut or loop shaped beam that corresponds to the shape of the sealing line 340. The lens is spaced from the sealing line by a distance such that the loop-shaped beam is the same size as the sealing line when it impinges upon the sealing line (e.g. the loop of frit or outer periphery of an absorbing glass patch) and the entire frit loop or perimeter of an absorbing glass patch is substantially uniformly heated by the loop-shaped beam. Again, the loop-shaped beam may be any desired looped shape that matches the shape of the sealing line. A mirror may be employed to direct the laser beam through the axicon lens.

### Experiment 1

A low CTE 2.2 mm thick soda lime glass plate with a hole with approximately 2 mm diameter was used. A glass patch was doped with vanadium oxide and copper oxide to make it a dark light absorbing glass patch with a relatively low CTE of approximately 35x10⁻⁷ per degree C. A focused laser beam was moved at a relatively slow speed of 10 mm/s at a power of 4 Watts in single pass around the sealing line in order to melt the absorbing glass and attach and seal the glass patch to the glass plate in a single pass. The resulting sample didn't have any visible cracks and appeared to be strong. The sample was subjected to thermal cycling test (-40-85C, 3C/min, 30 min hold, approximately 10 cycles). The sample showed a crack developed during thermal cycling due the presence of residual thermal stress.

### Experiment 2

The same sample glasses as that of Experiment 1 were sealed using a stationary loop-shaped beam. The heating profile was the same as shown in figure 6. In this case, the sealing line and the loop-shaped beam had a diameter of approximately 3 mm diameter. Peak beam power was approximately 11 Watts. The amount of thermal energy deposited to the sample was higher than for first experiment, but the seal area was larger as well. The resulting samples survived thermal cycle and a long term 85° C test without any visible degradation to the seal. The seal was strong. Attempts to separate the glasses broke unsealed portions of the glass, but sealed area stayed intact. Gradual cooling of the seal around the strain point of the glass with the lower strain temperature was shown to reduce the amount of residual stresses, even in glasses having a CTE mismatch.

Experiments with soda lime glass patches with a CTE matching that of a soda lime glass plate with the hole being sealed produced cracks during sealing, even with longer cool down times. This suggests that transient stresses in this case were too high to hold the seal together. Another experiment using soda lime glass plates and a relatively low CTE glass patch produced good results when the glass patches had a thickness of about 0.7 mm or less and a heating profile with slow cooling as illustrated in Fig. 6 was used. In the case of sealing the holes with relatively lower CTE glass patches, the frit sealing may not require any special heating profile management. These experiments show that a relatively low CTE glass patches performs better, even when sealing a hole in a relatively high CTE glass plate, than sealing with a soda lime glass patch.

Embodiments describe herein provide a process for encapsulating and sealing of a relatively small hole (<2 mm) in soda lime glass (or other relatively high CTE glass with a CTE of about 80-90x10⁻⁷ per degree C) with a relatively low CTE glass patch using either light absorbing frit sealing or a light absorbing glass patch. The process forms an inorganic, hermetic, mechanically stable seal. Advantages of the disclosed process and resulting sealed glass package include: a hermetic seal with low residual stress, mechanical stability; no leaks of the solution in the cell cavity; and a relatively long sealed life for the sealed package.

Embodiments describe herein provide a method of hermetically sealing a fill hole in a glass package, the glass package including a first glass plate and a second glass plate, an outer peripheral portion of the first glass plate being attached and sealed to an outer peripheral portion of the second glass plate, with the first glass plate spaced from the second glass plate defining a cell cavity between the first glass plate and the second glass plate, at least one fill hole passing through the second glass plate in communication with the cell cavity, the cell cavity being filled with a heat sensitive liquid, the method comprising the steps of: obtaining a glass patch having an inner surface and an outer surface and a loop-shaped sealing line on the inner surface of the glass patch; placing the inner surface of the glass patch on an outer surface of the second glass plate over the at least one fill hole with the sealing line surrounding the at least one fill hole; and uniformly heating the sealing line with a focused high intensity beam of light having a wavelength outside of the absorbing range of the cell components to a substantially uniform temperature at least as high as a melting temperature of the sealing line to melt the sealing line and thereby hermetically seal the fill hole with the glass patch without heating the heat sensitive liquid to a temperature over of about 150°C.

The first and second glass plates may have a CTE in a range from about 80x10⁻⁷ to about 90x10⁻⁷ per degree C. The glass patch may have a CTE of less than about 50x10⁻⁷ per degree C. The glass patch may have a thickness of less than about 0.7mm. The first and second glass plates may have a thickness of more than about 2.2mm. The first and second glass plates may be soda lime glass plates.

The uniformly heating step may melt the sealing line without heating the organic electrolyte solution to a temperature over of 120°C. The step of uniformed heating may be performed by heating the sealing with a focused beam of light.

The sealing line may be formed of light absorbing glass frit. Alternatively, the sealing line may be formed by doping the glass patch with at least one of V oxide, Cu oxide, Ti oxide, Fe oxide and Cu at least along the sealing to make at least the sealing line light absorbing glass. Also, the second glass plate may be formed of a dark glass having a composition that includes by weight percentage a composition including 54.92% SiO₂, 5.93% Al₂O₃, 23.27% B₂O₃, 0.43% Li₂O, 1.92% K₂O, 3.25% Fe₂O₃, 6.13% CuO, 2.64% V₂O₅, 1.48% C1, such that the sealing line is light absorbing.

The focused beam of light may be a laser beam that is rapidly and repeatedly scanned around the sealing line at a speed of from about 1mls to about 2m/s. The sealing line may be formed of light absorbing glass frit that has a width of about 0.7mm and the laser beam has a spot size of 1mm.

The focused beam of light may be a loop shaped beam of light with a size and shape corresponding to the sealing line.

At least an outer peripheral portion of the glass patch may be formed of a light absorbing glass, and the step of substantially uniformly heating the entire loop of inorganic sealing material is performed by irradiating the sealing line with high intensity light.

Following the uniformly heating step, there may be a step of gradually cooling the glass package over at least at least 20- 30 seconds. The step of gradually cooling the glass package may include comprises: gradually decreasing a power of the focused light beam at a first rate of power reduction down to gradually lower the temperature of the sealing line down to its annealing point; and gradually decreasing a power of the focused light beam at a second rate of power reduction that is slower than the first rate of power reduction down to zero power.

The uniform heating step may include: during a start-up phase, quickly ramping the concentrated light beam up to peak power and from T0 to T1; during a heating phase from T1 to T2, maintaining the focused light beam at peak power in order to raise the sealing line its melting temperature. Following the uniformly heating step, there may be a step of gradually cooling the glass package, wherein the gradually cooling step comprises: during a first cool down phase, gradually decreasing a power of the focused light beam at a first rate of power reduction down to gradually lower the temperature of the sealing line down to its annealing point; and during a first cool down phase, gradually decreasing a power of the focused light beam at a second rate of power reduction that is slower than the first rate of power reduction down to zero power.

The focused light beam may a laser beam with a peak power of 10 watts.

The sealed glass package may be an organic dye solar cell and the heat sensitive liquid may be an organic electrolyte solution.

## Claims

1. A method of hermetically sealing a fill hole (42, 44) in a glass package, the glass package including a first glass (12) plate and a second glass plate (14), an outer peripheral portion of the first glass plate (12) being attached and sealed to an outer peripheral portion of the second glass plate (14), with the first glass plate (12) spaced from the second glass plate (14) defining a cell cavity (40) between the first glass plate (12) and the second glass plate (14), at least one fill hole (42, 44) passing through the second glass plate (14), in communication with the cell cavity (40), the cell cavity (40) being filled with a heat sensitive liquid, said method being **characterized in that** it includes the steps of:
obtaining a glass patch (52, 54) having an inner surface and an outer surface and a loop-shaped sealing line (L) on the inner surface of the glass patch (52, 54);
placing the inner surface of the glass patch (52, 54) on an outer surface of the second glass plate (14), over the at least one fill hole (42, 44) with the sealing line (L) surrounding the at least one fill hole (42,44); and
uniformly heating the sealing line (L) with a focused high intensity beam of light having a wavelength outside of the absorbing range of the cell components to a substantially uniform temperature at least as high as a melting temperature of the sealing line (L) to melt the sealing line (L) and thereby hermetically seal the fill hole (42, 44) with the glass patch (52, 54) without heating the heat sensitive liquid to a temperature over 150°C.

2. The method according to claim 1, wherein one or more of:
(a) the first and second glass plates (12 and 14) have a CTE in a range from about 80x10⁻⁷ to about 90x10⁻⁷ per degree C;
(b) the glass patch (52, 54) has a CTE of less than about 50x10⁻⁷ per degree C;
(c) the glass patch (52, 54) has a thickness of less than about 0.7 mm;
(d) the first and second glass plates (12 and 14) have a thickness of more than about 2.2 mm; and
(e) the first and second glass plates (12 and 14) are soda lime glass plates.

3. The method according to claim 1 or 2, wherein the uniformly heating step is performed by heating the sealing line (L) with a focused beam of light in order to melt the sealing line (L) without heating the organic electrolyte solution to a temperature over 120°C.

4. The method according to any one of claims 1 to 3, wherein the sealing line (L) is formed by one of:
(a) light absorbing glass frit;
(b) a glass patch doped with at least one of V oxide, Cu oxide, Ti oxide, Fe oxide and Cu at least along the sealing to make at least the sealing line light absorbing glass; or
(c) a dark glass having by weight percentage a composition including 54.92% SiO₂, 5.93% Al₂O₃, 23.27% B₂O₃, 0.43% Li₂O, 1.92% K₂O, 3.25% Fe₂0₃, 6.13% CuO, 2.64% V₂O₅, 1.48% Cl, such that at least the sealing line (L) is light absorbing.

5. The method according to any one of claims 3 and 4, wherein the focused beam of light has a wavelength that is one of:
(a) longer than about 750 nm;
(b) longer than about 800 nm;
(c) or longer than about 810 nm.

6. The method according to any one of claims 3 to 5, wherein the focused beam of light is a laser beam that is rapidly and repeatedly scanned around the sealing line (L) at a speed of from about 1 m/s to about 2 m/s.

7. The method according to claim 6, wherein the sealing line is formed of light absorbing glass frit that has a width of about 0.7 mm and the laser beam has a spot size of 1 mm.

8. The method according to any one of claims 3 to 5, wherein the focused beam of light is a loop shaped beam of light with a size and shape corresponding to the sealing line (L).

9. The method according to any one of claims 1 to 8, wherein at least an outer peripheral portion of the glass patch (52, 54) is formed of a light absorbing glass, and the step of substantially uniformly heating the entire loop of inorganic sealing material is performed by irradiating the sealing line (L) with high intensity light.

10. The method according to any one of claims 1 to 9, wherein, following the uniformly heating step, it further comprises the step of gradually cooling the glass package over at least 20 - 30 seconds.

11. The method according to any one of claims 1 to 10, wherein, following the uniformly heating step, it further comprises the step of gradually cooling the glass package, said gradually cooling step comprising:
gradually decreasing a power of the focused light beam at a first rate of power reduction gradually cooling the sealing line down to its annealing point; and
gradually decreasing a power of the focused light beam at a second rate of power reduction that is slower than the first rate of power reduction down to zero power gradually cooling the sealing line down to room temperature.

12. The method according to any one of claims 1 to 11, wherein the uniform heating step comprises:
during a start up phase, quickly ramping the concentrated light beam up to peak power;
during a heating phase, maintaining the focused light beam at peak power in order to raise the sealing line its melting temperature.

13. The method according to any one of claims 5 to 8, wherein the focused light beam is a laser beam and peak power is 10 watts.

14. The method according to any one of claims 1 to 13, wherein the sealed glass package is an organic dye solar cell and the heat sensitive liquid is an organic electrolyte solution.

## Patentansprüche

1. Verfahren zum hermetischen Abdichten eines Fülllochs (42, 44) in einer Glaspackung, wobei die Glaspackung eine erste Glasplatte (12) und eine zweite Glasplatte (14) umfasst, ein äußerer Randteil der ersten Glasplatte (12) an einem äußeren Randteil der zweiten Glasplatte (14) befestigt und gegen dieselbe abgedichtet ist, wobei die erste Glasplatte (12) mit einem Abstand zur zweiten Glasplatte (14) angeordnet ist und so einen Zellhohlraum (40) zwischen der ersten Glasplatte (12) und der zweiten Glasplatte (14) definiert, wobei mindestens eines Fülllochs (42, 44) durch die zweite Glasplatte (14) geht, in Kommunikation mit dem Zellhohlraum (40), wobei der Zellhohlraum (40) mit einer wärmeempfindlichen Flüssigkeit gefüllt ist, wobei das Verfahren **dadurch gekennzeichnet ist, dass** es die folgenden Schritte umfasst:
Gewinnen eines Glaspflasters (52, 54), das eine Innenfläche und eine Außenfläche und eine schleifenförmige Abdichtlinie (L) auf der Innenfläche des Glaspflasters (52, 54),
Platzieren der Innenfläche des Glaspflasters (52, 54) auf einer Außenfläche der zweiten Glasplatte (14) über dem mindestens einen Füllloch (42, 44), wobei die Abdichtlinie (L) das mindestens eine Füllloch (42, 44) umgibt, und
Gleichförmiges Erwärmen der Abdichtlinie (L) mit einem fokussierten hoch intensiven Lichtstrahl, der eine Wellenlänge außerhalb des Absorptionsbereichs der Zellkomponenten hat, auf eine im Wesentlichen gleichförmige Temperatur, zumindest so hoch wie eine Schmelztemperatur der Abdichtlinie (L), um die Abdichtlinie (L) zu schmelzen und dadurch das Füllloch (42, 44) mit dem Glaspflaster (52, 54) hermetisch abzudichten, ohne die wärmeempfindliche Flüssigkeit auf eine Temperatur von mehr als 150 °C zu erwärmen.

2. Verfahren nach Anspruch 1, wobei eine oder mehrere der folgenden Angaben gelten:
(a) die erste und zweite Glasplatte (12 und 14) haben ein CTE (Ausdehnungskoeffizienten)in einem Bereich von etwa 80x10⁻⁷ bis etwa 90x10⁻⁷ pro Grad Celsius,
(b) das Glaspflaster (52, 54) hat ein CTE von weniger als etwa 50x10⁻⁷ pro Grad Celsius,
(c) das Glaspflaster (52, 54) hat eine Dicke von weniger als etwa 0,7 mm,
(d) die erste und zweite Glasplatte (12 und 14) haben eine Dicke von mehr als etwa 2,2 mm, und
(e) die erste und zweite Glasplatte (12 und 14) sind Natronkalk-Glasplatten.

3. Verfahren nach Anspruch 1 oder 2, wobei der gleichförmige Erwärmungsschritt ausgeführt wird durch Erwärmen der Abdichtlinie (L) mit einem fokussierten Lichtstrahl, um die Abdichtlinie (L) zu schmelzen, ohne die organische Elektrolytlösung auf eine Temperatur von mehr als 120 °C zu erwärmen.

4. Verfahren nach einem der Ansprüche 1 bis 3, wobei die Abdichtlinie (L) durch eine der folgenden Substanzen gebildet wird:
(a) lichtabsorbierende Glasfritte,
(b) ein Glaspflaster, das mit mindestens einer Substanz aus V-Oxid, Cu-Oxid, Ti-Oxid, Fe-Oxid und Cu zumindest entlang der Abdichtung, um zumindest die Abdichtlinie zu lichtabsorbierendem Glas zu machen, oder
(c) ein dunkles Glas, das nach dem Gewichtsanteil eine Zusammensetzung umfasst, welche 54,92 % SiO₂, 5,93 % Al₂O₃, 23,27 % B₂O₃, 0,43 % Li₂O, 1,92 % K₂O, 3,25 % Fe₂O₃, 6,13 % CuO, 2,64 % V₂O₅, 1,48 % Cl umfasst, so dass die mindestens eine Abdichtlinie (L) lichtabsorbierend ist.

5. Verfahren nach einem der Ansprüche 3 und 4, wobei der fokussierte Lichtstrahl eine Wellenlänge hat, die eine der folgenden ist:
(a) länger als etwa 750 nm,
(b) länger als etwa 800 nm,
(c) oder länger als etwa 810 nm.

6. Verfahren nach einem der Ansprüche 3 bis 5, wobei der fokussierte Lichtstrahl ein Laserstrahl ist, der schnell und wiederholt die Abdichtlinie (L) mit einer Geschwindigkeit von etwa 1 m/s bis etwa 2 m/s überstreicht.

7. Verfahren nach Anspruch 6, wobei die Abdichtlinie aus lichtabsorbierender Glasfritte gebildet ist, die eine Breite von etwa 0,7 mm hat und der Laserstrahl eine Spotgröße von 1 mm hat.

8. Verfahren nach einem der Ansprüche 3 bis 5, wobei der fokussierte Lichtstrahl ein schleifenförmiger Lichtstrahl mit einer Größe und Form ist, die der Abdichtlinie (L) entsprechen.

9. Verfahren nach einem der Ansprüche 1 bis 8, wobei mindestens ein äußerer Peripherieteil des Glaspflasters (52, 54) aus einem lichtabsorbierenden Glas gebildet ist, und der Schritt des im Wesentlichen gleichförmigen Erwärmens der ganze Schleife von anorganischem Abdichtmaterial wird durch Bestrahlen der Abdichtlinie (L) mit Hochintensitätslicht ausgeführt.

10. Verfahren nach einem der Ansprüche 1 bis 9, wobei nach dem gleichförmigen Erwärmungsschritt es ferner den Schritt des allmählichen Abkühlens der Glaspackung über mindestens 20 - 30 Sekunden umfasst.

11. Verfahren nach einem der Ansprüche 1 bis 10, wobei nach dem gleichförmigen Erwärmungsschritt es ferner den Schritt des allmählichen Abkühlens der Glaspackung umfasst, wobei der Schritt des allmählichen Abkühlens umfasst:
allmähliches Verringern einer Leistung des fokussierten Lichtstrahls mit einer ersten Rate der Leistungsreduzierung, allmähliches Abkühlen der Abdichtlinie bis auf ihren Konditionierungspunkt, und
allmähliches Verringern einer Leistung des fokussierten Lichtstrahls mit einer zweiten Rate der Leistungsreduzierung, die langsamer als die erste Rate der Leistungsreduzierung ist, bis zu null Leistung, allmähliches Abkühlen der Abdichtlinie auf Raumtemperatur.

12. Verfahren nach einem der Ansprüche 1 bis 11, wobei der gleichförmige Erwärmungsschritt umfasst:
während einer Startphase den konzentrierten Lichtstrahl schnell auf Spitzenleistung hochfahren,
während einer Erwärmungsphase den fokussierten Lichtstrahl auf Spitzenleistung halten, um die Abdichtlinie auf ihre Schmelztemperatur zu bringen.

13. Verfahren nach einem der Ansprüche 5 bis 8, wobei der fokussierte Lichtstrahl ein Laserstrahl ist und die Spitzenleistung 10 Watt beträgt.

14. Verfahren nach einem der Ansprüche 1 bis 13, wobei die abgedichtete Glaspackung eine organische Farbstofifsolarzelle ist und die wärmeempfindliche Flüssigkeit eine organische Elektrolytlösung ist.

## Revendications

1. Procédé de scellement hermétique d'un trou de remplissage (42, 44) dans un conditionnement en verre, le conditionnement en verre comprenant une première plaque de verre (12) et une seconde plaque de verre (14), une portion périphérique externe de la première plaque de verre (12) étant fixée et scellée à une portion périphérique externe de la seconde plaque de verre (14), avec la première plaque de verre (12) espacée de la seconde plaque de verre (14) définissant une cavité de cellule (40) entre la première plaque de verre (12) et la seconde plaque de verre (14), au moins un trou de remplissage (42, 44) passant à travers la seconde plaque de verre (14), en communication avec la cavité de cellule (40), la cavité de cellule (40) étant remplie avec un liquide thermosensible, ledit procédé étant **caractérisé en ce qu'**il comprend les étapes :
d'obtention d'une patch de verre (52, 54) présentant une surface interne et une surface externe et une ligne de scellement en forme de boucle (L) sur la surface interne du patch de verre (52, 54) ;
de placement de la surface interne du patch de verre (52, 54) sur une surface externe de la seconde plaque de verre (14), sur le au moins un trou de remplissage (42, 44) avec la ligne de scellement (L) entourant le au moins un trou de remplissage (42, 44) ; et
de chauffage uniforme de la ligne de scellement (L) avec un faisceau de lumière concentré d'intensité élevée présentant une longueur d'onde à l'extérieur de l'intervalle d'absorption des constituants de la cellule à une température pratiquement uniforme au moins aussi élevée qu'une température de fusion de la ligne de scellement (L) pour faire fondre la ligne de scellement (L) et sceller par-là hermétiquement le trou de remplissage (42, 44) avec le patch de verre (52, 54) sans chauffer le liquide thermosensible à une température supérieure à 150°C.

2. Procédé selon la revendication 1, dans lequel une ou plusieurs parmi :
(a) les première et seconde plaques de verre (12 et 14) présentent un CTE dans un intervalle d'environ 80 x 10⁻⁷ à environ 90 x 10⁻⁷ par degré C ;
(b) le patch de verre (52, 54) présente un CTE inférieur à environ 50 x 10⁻⁷ par degré C ;
(c) le patch de verre (52, 54) présente une épaisseur inférieure à environ 0,7 mm ;
(d) les première et seconde plaques de verre (12 et 14) présentent une épaisseur supérieure à environ 2,2 mm ; et
(e) les première et seconde plaques de verre (12 et 14) sont des plaques de verre sodocalcique.

3. Procédé selon la revendication 1 ou 2, dans lequel l'étape de chauffage uniforme est réalisée en chauffant la ligne de scellement (L) avec un faisceau de lumière concentré afin de faire fondre la ligne de scellement (L) sans chauffer la solution d'électrolyte organique à une température supérieure à 120°C.

4. Procédé selon l'une quelconque des revendications 1 à 3, dans lequel la ligne de scellement (L) est formée par l'un parmi :
(a) une fritte de verre absorbant la lumière ;
(b) un patch de verre dopé avec au moins un parmi un oxyde de V, oxyde de Cu, oxyde de Ti, oxyde de Fe et Cu au moins le long du scellement pour constituer au moins le verre absorbant la lumière de la ligne de scellement ; ou
(c) un verre sombre présentant, en pourcentage en masse, une composition comprenant 54,92 % de SiO₂, 5,93 % de Al₂O₃, 23,27 % de B₂O₃, 0,43 % de Li₂O, 1,92 % de K₂O, 3,25 % de Fe₂O₃, 6,13 % de CuO, 2,64 % de V₂O₅, 1,48 % de Cl, de sorte qu'au moins la ligne de scellement (L) absorbe la lumière.

5. Procédé selon l'une quelconque des revendications 3 et 4, dans lequel le faisceau de lumière concentré présente une longueur d'onde qui est une parmi :
(a) plus longue qu'environ 750 nm ;
(b) plus longue qu'environ 800 nm ;
(c) ou plus longue qu'environ 810 nm.

6. Procédé selon l'une quelconque des revendications 3 à 5, dans lequel le faisceau concentré de lumière est un faisceau laser qui est rapidement et répétitivement balayé autour de la ligne de scellement (L) à une vitesse d'environ 1 m/s à environ 2 m/s.

7. Procédé selon la revendication 6, dans lequel la ligne de scellement est formée par une fritte de verre absorbant la lumière qui présente une largeur d'environ 0,7 mm et le faisceau laser a une taille de point lumineux de 1 mm.

8. Procédé selon l'une quelconque des revendications 3 à 5, dans lequel le faisceau de lumière concentré est un faisceau de lumière en forme de boucle avec une taille et une forme correspondant à la ligne de scellement (L).

9. Procédé selon l'une quelconque des revendications 1 à 8, dans lequel au moins une portion périphérique externe du patch de verre (52, 54) est formée d'un verre absorbant la lumière, et l'étape de chauffage pratiquement uniforme de la boucle entière du matériau de scellement inorganique est réalisée en irradiant la ligne de scellement (L) avec de la lumière d'intensité élevée.

10. Procédé selon l'une quelconque des revendications 1 à 9, dans lequel, après l'étape de chauffage uniforme, il comprend de plus l'étape de refroidissement progressif du conditionnement en verre pendant au moins 20-30 secondes.

11. Procédé selon l'une quelconque des revendications 1 à 10, dans lequel, après l'étape de chauffage uniforme, il comprend de plus l'étape de refroidissement progressif du conditionnement en verre, ladite étape de refroidissement progressif comprenant :
la diminution progressive d'une puissance du faisceau de lumière concentré à une première vitesse de réduction de puissance refroidissant progressivement la ligne de scellement jusqu'à son point de recuit ; et
la diminution progressive d'une puissance du faisceau de lumière concentré à une seconde vitesse de réduction de puissance qui est plus lente que la première vitesse de réduction de puissance jusqu'à une puissance zéro refroidissant progressivement la ligne de scellement jusqu'à la température ambiante.

12. Procédé selon l'une quelconque des revendications 1 à 11, dans lequel l'étape de chauffage uniforme comprend :
pendant une phase de démarrage, l'élévation rapide du faisceau de lumière concentré jusqu'à une puissance de pic ;
pendant une phase de chauffage, le maintien du faisceau de lumière concentré à une puissance de pic afin d'élever la ligne de scellement à sa température de fusion.

13. Procédé selon l'une quelconque des revendications 5 à 8, dans lequel le faisceau de lumière concentré est un faisceau laser et la puissance de pic est de 10 watts.

14. Procédé selon l'une quelconque des revendications 1 à 13, dans lequel le conditionnement en verre scellé est une pile solaire à colorant organique et le liquide thermosensible est une solution d'électrolyte organique.
